# EUROPÄISCHE PATENTANMELDUNG

(11) **EP 1 265 465 A2**
(43) Veröffentlichungstag der Anmeldung: **11.12.2002**
(21) Anmeldenummer: 02010339.6
(22) Anmeldetag: 07.05.2002
(51) Int. Cl.: H05K 1/11, H05K 1/18

(54) **Leiterplatte**

(30) Priorität: 06.06.2001 DE 10127334
(71) Anmelder: Patent-Treuhand-Gesellschaft für elektrische Glühlampen mbH, 81543 München (DE)
(72) Erfinder: Gurel, Axel, 82166 Gräfelfing (DE); Huber, Andreas, 82216 Maisach (DE); Niedermeier, Peter, 80995 München (DE); Reiter, Bernhard, 81541 München (DE)

(57) **Zusammenfassung**

Die vorliegende Erfindung betrifft eine Leiterplatte zum ein- oder zweiseitigen Verlöten und/oder Bestücken von elektronischen Bauelementen, wobei die einzelnen Bauelemente mindestens ein elektrisch leitendes Kontaktelement zum Einführen In mindestens eine entsprechende, die Leiterplatte (10) durchdringende Kontaktöffnung (12) aufweisen, wobei die Kontaktöffnung (12) der Leiterplatte (10) schlitzförmig ausgebildet Ist.

## Beschreibung

Die Erfindung geht aus von einer Leiterplatte gemäß dem Oberbegriff des Anspruchs 1. Es handelt sich dabei insbesondere um eine Leiterplatte zum ein- oder zweiseitigen Verlöten und/oder Bestücken von elektronischen Bauelementen, wobei die einzelnen Bauelemente mindestens ein elektrisch leitendes Kontaktelement zum Einführen in mindestens eine entsprechende, die Leiterplatte durchdringende Kontaktöffnung aufweisen.

### Stand der Technik

Derartige Leiterplatten sind bekannt. Um derartige Leiterplatten mit elektronischen Bauelementen verbinden zu können, weisen bekannte Leiterplatten runde, die Leiterplatte durchdringende Bohrungen auf, die üblicherweise durchkontaktiert sind. In diese Öffnungen werden entsprechende Kontaktelemente bzw. Kontaktstifte der mit der Leiterplatte zu verbindenden elektronischen Bauelemente gesteckt. Anschließend erfolgt ein Verlöten dieser Kontaktelemente mit den durchkontaktierten Bohrungen der Leiterplatte oder mit entsprechenden Leiterbahnen der Leiterplatte.

Nachteilig an diesen bekannten Leiterplatten ist jedoch, daß bei der Verwendung der beschriebenen herkömmlichen Bohrungen für die Montage von elektronischen Standardbauteilen keine niedrige Bauweise möglich ist, da diese Bauteile aufgrund der Verbreiterung der Kontaktelemente bzw. Kontaktstifte zum Bauteil hin nicht tief genug in die Leiterplatte eingesteckt werden können. Um eine möglichst niedrige Bautiefe zu erzielen, wurden bisher teure Spezialbauteile wie z.B. SMD-Bauteile verwendet.

### Darstellung der Erfindung

Es ist Aufgabe der vorliegenden Erfindung, eine Leiterplatte gemäß dem Oberbegriff des Anspruchs 1 bereitzustellen, die bei der Bestückung mit elektronischen Standardbauteilen eine möglichst niedrige Bauhöhe gewährleistet.

Diese Aufgabe wird bei einer Leiterplatte mit den Merkmalen des Oberbegriffs des Anspruchs 1 durch die Merkmale des kennzeichnenden Teils des Anspruchs 1 gelöst. Besonders vorteilhafte Ausgestaltungen finden sich in den abhängigen Ansprüchen.

Eine erfindungsgemäße Leiterplatte weist mindestens eine Kontaktöffnung zum Einführen von elektrisch leitenden Kontaktelementen von elektronischen Bauelementen auf, die schlitzförmig ausgebildet ist. Durch diese Ausgestaltung der Kontaktöffnung der Leiterplatte Ist es möglich, daß die Kontaktelemente bzw. Kontaktstifte der Bauelemente vollständig oder nahezu vollständig in die Leiterplatte eingeführt werden können, so daß das Gehäuse der elektronischen Bauelemente auf der Leiterplatte aufliegt oder in nur sehr geringem Abstand davon zum Liegen kommt. Dadurch ist insgesamt eine sehr niedrige Bauhöhe des gesamten Elements bestehend aus Leiterplatte und darauf befestigtem elektronischen Bauelement gewährleistet.

In einer vorteilhaften Ausgestaltung der Erfindung ist die schlitzförmige Kontaktöffnung zur Durchkontaktierung metallisiert. Dies ist insbesondere bei doppelseitigen Leiterplatten von Vorteil, da somit eine Bestückung von Leiterplatten mit Bauelementen auf einer Seite und deren Verbindung mit den Leiterbahnen der Leiterplatte auf der gegenüberliegenden Seite der Leiterplatte möglich ist.

In einer weiteren vorteilhaften Ausgestaltung der erfindungsgemäßen Leiterplatte weist die schlitzförmige Kontaktöffnung mindestens eine senkrecht zur Längsachse der Kontaktöffnung verlaufende schlitzförmige Queröffnung auf. Es ist aber auch möglich, daß die schlitzförmige Queröffnung schräg zur Längsachse der Kontaktöffnung verläuft. Die Querfräsungen dienen zur Isolation der einzelnen Leiterbahnen für die jeweiligen Kontaktelemente bzw. Kontaktstifte der Bauteile. Der Isolationsabstand zwischen den einzelnen Kontaktelementen ist bei einer entsprechenden Breite der schlitzförmigen Queröffnung maximal, zudem vergrößern sich vorteilhafterweise durch die schlitzförmigen Queröffnungen die Kriechstrecken. Des weiteren ist es vorteilhafterweise möglich, durch eine geeignete Wahl der Schlitzlängen der Kontaktöffnung und/oder der Queröffnung ein selbständiges Zentrieren der einzusteckenden Bauteile zu gewährleisten.

In einer weiteren vorteilhaften Ausgestaltung der Erfindung sind die Kontaktöffnung und die Queröffnung mittels Bohren, Fräsen oder Stanzen ausbildbar.

### Beschreibung der Zeichnungen

Im folgenden soll die Erfindung anhand mehrerer Ausführungsbeispiele näher erläutert werden. Es zeigen:
- Figur 1: eine schematische Darstellung einer erfindungsgemäßen Leiterplatte; und
- Figur 2: eine schematische Darstellung einer erfindungsgemäßen Leiterplatte gemäß einem weiteren Ausführungsbeispiel.

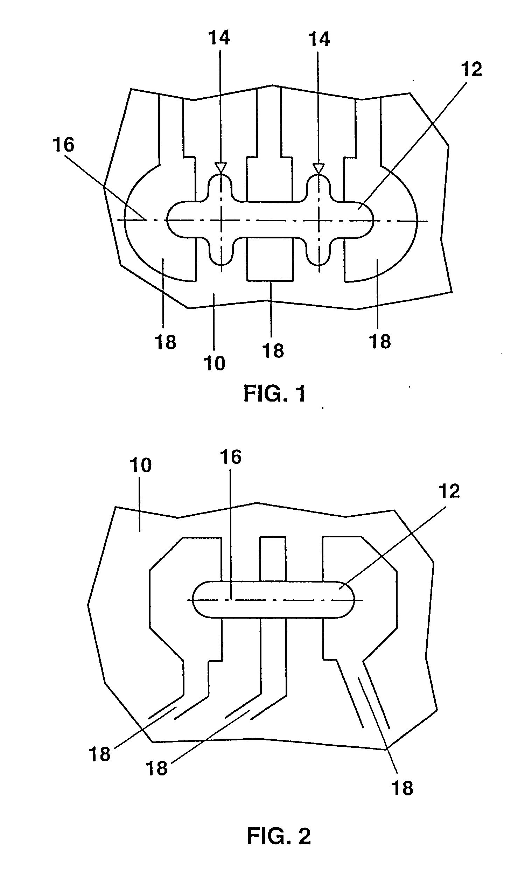

Figur 1 zeigt in einer schematischen Darstellung eine Leiterplatte 10 mit metallisierten Leiterbahnen 18. In dem gezeigten Ausführungsbeispiel handelt es sich um eine doppelseitige Leiterplatte. Von der nicht dargestellten Seite der Leiterplatte 10 her werden Kontaktelemente, insbesondere Kontaktstifte, von einzelnen Bauelementen, insbesondere elektronischen Bauelementen, in eine Kontaktöffnung 12 der Leiterplatte 10 eingeführt. Man erkennt, daß die Kontaktöffnung 12 schlitzförmig ausgebildet ist, wobei ungefähr senkrecht zu einer Längsachse 16 der Kontaktöffnung 12 ebenfalls schlitzförmige Queröffnungen 14 ausgebildet sind. Die Queröffnungen 14 verlaufen dabei ungefähr parallel zu den Leiterbahnen 18 und ragen über beide Längsseiten der Kontaktöffnung 12 hinaus. Im Gegensatz zu der schlitzförmigen Kontaktöffnung 12 sind die Queröffnungen 14 nicht metallisiert und dienen zur Isolation der einzelnen Leiterbahnen 18 und der entsprechenden Kontaktelemente des elektronischen Bauelementes voneinander.

Die schlitzförmige Kontaktöffnung 12 sowie die schlitzförmigen Queröffnungen 14 können durch Bohren, Fräsen oder Stanzen hergestellt werden.

Figur 2 zeigt in einer schematischen Darstellung ein weiteres Ausführungsbeispiel einer Leiterplatte 10. Bei diesem Ausführungsbeispiel handelt es sich um eine einseitige Leiterplatte 10, die ebenfalls eine schlitzförmige Kontaktöffnung 12 mit einer entsprechenden Längsachse 16 aufweist. Man erkennt, daß die schlitzförmige Kontaktöffnung 12 drei Leiterbahnen 18 miteinander verbindet. Bei der dargestellten einseitigen Leiterplatte 10 ist die schlitzförmige Kontaktöffnung nicht metallisiert. Dies ist nur bei doppelseitigen Leiterplatten gemäß dem Ausführungsbeispiel in Figur 1 zur Durchkontaktierung notwendig.

Durch die besondere Ausgestaltung der Kontaktöffnungen 12 gemäß den Ausführungsbeispielen in den Figuren 1 und 2 ist es möglich, daß auf den Leiterplatten 10 zu befestigende Standardbauteile tiefer als bei herkömmlichen Leiterplatten eingesteckt werden können, so daß niedrigere Bauhöhen realisierbar sind.

## Patentansprüche

1. Leiterplatte zum ein- oder zweiseitigen Verlöten und/oder Bestücken von elektronischen Bauelementen, wobei die einzelnen Bauelemente mindestens ein elektrisch leitendes Kontaktelement zum Einführen in mindestens eine entsprechende, die Leiterplatte (10) durchdringende Kontaktöffnung (12) aufweisen, **dadurch gekennzeichnet, daß** die Kontaktöffnung (12) der Leiterplatte (10) schlitzförmig ausgebildet ist.

2. Leiterplatte nach Anspruch 1, **dadurch gekennzeichnet, daß** die schlitzförmige Kontaktöffnung (12) zur Durchkontaktierung metallisiert ist.

3. Leiterplatte nach Anspruch 1 oder 2, **dadurch gekennzeichnet, daß** die schlitzförmige Kontaktöffnung (12) mindestens eine senkrecht zur Längsachse (16) der Kontaktöffnung (12) verlaufende schlitzförmige Queröffnung (14) aufweist.

4. Leiterplatte nach Anspruch 1 oder 2, **dadurch gekennzeichnet, daß** die schlitzförmige Kontaktöffnung (12) mindestens eine schräg zur Längsachse (16) der Kontaktöffnung (12) verlaufende schlitzförmige Queröffnung aufweist.

5. Leiterplatte nach einem der vorhergehenden Ansprüche, **dadurch gekennzeichnet, daß** die Queröffnung (14) über beide Längsseiten der Kontaktöffnung (12) hinausragt.

6. Leiterplatte nach einem der vorhergehenden Ansprüche, **dadurch gekennzeichnet, daß** die Queröffnung (14) zur Isolation von zwei Kontaktelementen eines elektronischen Bauelements und der zugehörigen Leiterbahnen (18) der Leiterplatte (10) ausgebildet ist.

7. Leiterplatte nach einem der vorhergehenden Ansprüche, **dadurch gekennzeichnet, daß** die Kontaktöffnung und die Queröffnung mittels Bohren, Fräsen oder Stanzen ausbildbar sind.
